(19) **Europäisches Patentamt / European Patent Office / Office européen des brevets**

(11) **EP 4 541 768 A1**

(12) **EUROPEAN PATENT APPLICATION**
published in accordance with Art. 153(4) EPC

(43) Date of publication:
**23.04.2025 Bulletin 2025/17**

(21) Application number: **23827136.5**

(22) Date of filing: **16.06.2023**

(51) International Patent Classification (IPC):
$C01B\ 33/145^{(2006.01)}$    $B24B\ 37/00^{(2012.01)}$
$C01B\ 33/18^{(2006.01)}$    $H01L\ 21/304^{(2006.01)}$

(52) Cooperative Patent Classification (CPC):
**B24B 37/00; C01B 33/145; C01B 33/18; H01L 21/304**

(86) International application number:
**PCT/JP2023/022446**

(87) International publication number:
**WO 2023/248951 (28.12.2023 Gazette 2023/52)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **20.06.2022 JP 2022099053**

(71) Applicant: **Mitsubishi Chemical Corporation Tokyo 100-8251 (JP)**

(72) Inventor: **SHIMADA, Yuta Tokyo 100-8251 (JP)**

(74) Representative: **Hoffmann Eitle Patent- und Rechtsanwälte PartmbB Arabellastraße 30 81925 München (DE)**

(54) **SILICA PARTICLES, METHOD FOR PRODUCING SAME, SILICA SOL, POLISHING COMPOSITION, POLISHING METHOD, METHOD FOR PRODUCING SEMICONDUCTOR WAFER, AND METHOD FOR PRODUCING SEMICONDUCTOR DEVICE**

(57)    An object of the present invention is to provide silica particles, a silica sol, and a polishing composition that are excellent in mechanical strength, polishing properties, and storage stability. The present invention relates to silica particles having an average pore volume of atomic-scale pores of 0.35 nm³ or more as measured by positron annihilation spectroscopy.

EP 4 541 768 A1

## Description

Technical Field

The present invention relates to silica particles, a method for producing the silica particles, a silica sol, a polishing composition, a polishing method, a method for producing a semiconductor wafer, and a method for producing a semiconductor device.

Background Art

Polishing methods using a polishing solution are known as methods for polishing the surface of a material such as a metal or an inorganic compound. Particularly in final finish polishing of a prime silicon wafer for a semiconductor and a recycled silicon wafer thereof, and in chemical mechanical polishing (CMP) for planarization of an interlayer insulating film, formation of a metal plug, and formation of embedded wiring and the like during production of a semiconductor device, the surface state of these components greatly affects the semiconductor characteristics, and therefore the surfaces and end faces of these components are required to be polished with extremely high precision.

A polishing composition containing silica particles is used in such precision polishing, and colloidal silica is widely used as abrasive grains, i.e., a main component of the polishing composition. Various known types of colloidal silica are produced by different production methods, and include, for example, colloidal silica (fumed silica or the like) produced by thermal decomposition of silicon tetrachloride, colloidal silica produced by deionization of an alkali silicate such as water glass, and colloidal silica produced by hydrolysis reaction and condensation reaction (generally referred to as "sol-gel method") of an alkoxysilane.

Many studies have been conducted on methods for producing silica particles. For example, Patent Literatures 1 and 2 disclose a method for producing silica particles by subjecting an alkoxysilane to a hydrolysis reaction and a condensation reaction.

Citation List

Patent Literature

Patent Literature 1: JP H11-60232 A
Patent Literature 2: JP 2019-89692 A

Summary of Invention

Technical Problem

Generally, silica particles produced through hydrolysis reaction and condensation reaction of an alkoxysilane are not necessarily chemically or physically stable. More specifically, such silica particles known in the art do not necessarily have sufficiently high mechanical strength and storage stability against environmental factors such as irradiation with ultraviolet rays and an increase or decrease in temperature. When silica particles having insufficient mechanical strength and storage stability are used for polishing, the silica particles are broken due to physical impact during polishing and have an adverse effect on the polishing, such as adhesion of the broken silica particles to an object to be polished.

The silica particles produced by the production methods disclosed in Patent Literatures 1 and 2 are poor in mechanical strength, polishing properties, and storage stability.

The present invention has been made in view of such problems, and an object of the present invention is to provide silica particles, a silica sol, and a polishing composition that are excellent in mechanical strength, polishing properties, and storage stability. Another object of the present invention is to provide a polishing method that achieves excellent productivity of an object to be polished, a method for producing a semiconductor wafer, and a method for producing a semiconductor device.

Solution to Problem

Silica particles known in the art are not necessarily sufficient in mechanical strength, polishing properties, and storage stability. Thus, the present inventors have focused attention on the distortion of the siloxane network of silica particles as a cause of deterioration of the mechanical strength, polishing properties, and storage stability of the silica particles, and have conducted extensive studies regarding how to reduce this distortion. As a result, the present inventors have found that the distortion of the siloxane network of the silica particles is closely related to the size of pores of the silica particles. The present inventors have also found that optimization of the average pore volume of atomic-scale pores, sizes of which are measured by positron annihilation spectroscopy, can reduce the distortion of the siloxane network of the silica particles, and improves the mechanical strength, polishing properties, and storage stability of the silica particles. The present invention has been accomplished on the basis of this finding.

Specifically, the gist of the present invention is as follows.

[1] Silica particles having an average pore volume of atomic-scale pores of 0.35 nm$^3$ or more as measured by positron annihilation spectroscopy.

[2] The silica particles according to [1], wherein the silica particles have an average pore volume of atomic-scale pores of 0.40 nm$^3$ or more as measured by positron annihilation spectroscopy.

[3] The silica particles according to [1], wherein the silica particles have an average pore volume of atomic-scale pores of 1.0 nm$^3$ or less as measured by positron annihilation spectroscopy.

[4] The silica particles according to [1], wherein the silica particles have an average pore volume of atomic-scale pores of 0.80 nm$^3$ or less as measured by positron annihilation spectroscopy.

[5] The silica particles according to [1], wherein the silica particles have an average pore volume of nanoscale pores of 5.4 nm$^3$ or less as measured by positron annihilation spectroscopy.

[6] The silica particles according to [1], wherein the silica particles have a volume of pores having a diameter of 2 nm or less of 0.0070 cm$^3$/g or less as measured by a nitrogen gas adsorption method.

[7] The silica particles according to [1], wherein the silica particles have a refractive index of 1.390 or more.

[8] The silica particles according to [1], wherein a metal impurity content is 5 ppm or less.

[9] The silica particles according to [1], wherein the silica particles contain a tetraalkoxysilane condensate as a main component.

[10] A method for producing the silica particles described in any one of [1] to [9], the method including carrying out a hydrolysis reaction and a condensation reaction of an alkoxysilane for 600 minutes or less.

[11] A silica sol containing the silica particles described in any one of [1] to [9].

[12] A polishing composition containing the silica sol described in [11].

[13] A polishing method including polishing by using the polishing composition described in [12].

[14] A method for producing a semiconductor wafer, the method including polishing by using the polishing composition described in [12].

[15] A method for producing a semiconductor device, the method including polishing by using the polishing composition described in [12].

Advantageous Effects of Invention

The silica particles of the present invention have improved mechanical strength, polishing properties, and storage stability. The silica particles of the present invention are not easily broken in a step of polishing an object to be polished by using a polishing composition containing the silica particles.

Accordingly, by using a silica sol and a polishing composition containing the silica particles of the present invention, an object to be polished can be effectively polished without damage to the object, and the silica particles can be easily removed after polishing. Therefore, high-quality polished products can be produced with good productivity.

Description of Embodiments

The present invention will be described in detail below, but the present invention is not limited to the following embodiments and can be carried out with various modifications within the scope of the gist of the invention. In the present specification, a numerical range expressed by using the term "to" means that the numerical values or physical property values before and after "to" are included in the numerical range.

Silica Particles

The silica particles of the present invention have an average pore volume of atomic-scale pores as measured by positron annihilation spectroscopy (hereinafter also referred to simply as "average pore volume of atomic-scale pores") of 0.35 nm$^3$ or more, preferably 0.40 nm$^3$ or more, and more preferably 0.42 nm$^3$ or more. Thus, the distortion of the siloxane network of the silica particles is reduced, and the mechanical strength, polishing properties, and storage stability of the silica particles can be improved.

The distortion occurring in the siloxane network of the silica particles is thought to be due to the fact that a very low growth rate of the silica particles leads to formation of bonds between two or more of the four dangling bonds of a silicon atom and dangling bonds of adjacent silicon atoms, resulting in failure to form a more stable structure. The distortion of the siloxane network affects the size of atomic-scale pores. This is because when a silicon atom forms a bond with a dangling bond of an adjacent silicon atom, the space in a ring surrounded by siloxane structures becomes small. The distorted siloxane network structure causes a decrease in the mechanical strength of the silica particles. In addition, silica particles having a distorted siloxane network structure are poor in storage stability because chemical bonds are easily broken due to environmental factors such as irradiation with ultraviolet rays and an increase or decrease in temperature. Furthermore, when silica particles having a distorted siloxane network structure are used for polishing, the silica particles are broken due to physical impact during polishing and have an adverse effect on the polishing, such as adhesion of the broken silica particles to an object to be polished.

In the silica particles of the present invention, the average pore volume of atomic-scale pores is set to fall within the above-described range. Thus, it is considered that the distortion of the siloxane network is effectively reduced, and the mechanical strength, polishing properties, and storage stability of the silica particles are improved.

The upper limit of the average pore volume of the atomic-scale pores of the silica particles is not particularly limited. However, from the viewpoint of maintaining mechanical strength, the upper limit is preferably $1.0\,\mathrm{nm}^3$ or less, more preferably $0.80\,\mathrm{nm}^3$ or less, and even more preferably $0.60\,\mathrm{nm}^3$ or less.

Positron annihilation spectroscopy is a method by which the lifetime of a positron is measured based on the time difference between the moment at which the positron is emitted and the moment at which a $\gamma$-ray is generated upon the positron annihilation is observed. When positrons are incident on a material, the larger the void defects in the material, the longer the lifetime of the positrons. This property can be used to measure the average pore volume of the atomic-scale pores of the silica particles and the below-described average pore volume of nanoscale pores of the silica particles.

In the present specification, the average pore volume of the atomic-scale pores of the silica particles is a value measured by positron annihilation spectroscopy. Specifically, dried silica particles are subjected to positron annihilation spectroscopy and a positron lifetime spectrum is obtained. The positron lifetime spectrum is fitted to a linear sum of four exponential components to determine an average lifetime of positrons of each component. Among the four exponential components, the two components having shorter lifetimes are components having no involvement in the material. The component having the third shortest lifetime is a component corresponding to atomic-scale pores, and the average pore volume is determined by applying the average lifetime thereof to the following equation to convert the average lifetime into the pore volume. Primarily, the volume of pores having a volume of $1\,\mathrm{nm}^3$ or less in the silica particles, such as the volume of pores inside the ring structure of a siloxane network, can be determined from the obtained average pore volume of the atomic-scale pores of the silica particles.

The relational expression between the positron lifetime and the pore volume was obtained with reference to K. Wada et al., J. Phys.: Conf. Ser. 443, 012003 (2013).

[Equation 1]

$$\tau = 0.5 \left\{ 1 - \frac{R}{R + \Delta R} + \frac{1}{2\pi} \sin\left( \frac{2\pi R}{R + \Delta R} \right) \right\}^{-1}$$
$$(\Delta R = 0.165\,\mathrm{nm})$$

In these equations,

[Equation 2]

$$V = \frac{4}{3}\pi R^3$$

$\tau$ is the average lifetime of positrons, R is the average radius of atomic-scale pores, $\Delta R$ is the correction value of the radius of the atomic-scale pores, and V is the average pore volume of the atomic-scale pores.

The component having the longest lifetime is a component corresponding to nanoscale pores described below.

Another means for measuring the pore volume is a method based on gas adsorption and desorption, such as a nitrogen gas adsorption method, but the gas adsorption and desorption method is problematic in that closed pores cannot be measured, and errors occur in measurement results due to a chemical interaction between the object to be measured and a probe gas. In contrast, positron annihilation spectroscopy can also measure the volume of closed pores and does not depend on the surface state of the object to be measured, and therefore highly accurate measurements can be achieved.

From the viewpoint of further improving the mechanical strength, polishing properties, and storage stability of the silica particles, the average pore volume of nanoscale pores of the silica particles as measured by positron annihilation spectroscopy (hereinafter also referred to simply as the "average pore volume of nanoscale pores") is preferably 5.4 nm$^3$ or less, more preferably 5.3 nm$^3$ or less, and even more preferably 5.2 nm$^3$ or less. Moreover, from the viewpoint of maintaining the flexibility of the particles and preventing scratches during polishing, the average pore volume of the nanoscale pores is preferably 1.5 nm$^3$ or more, more preferably 2.5 nm$^3$ or more, and even more preferably 3.5 nm$^3$ or more.

In the present specification, the average pore volume of the nanoscale pores of the silica particles is a value measured by positron annihilation spectroscopy. A positron lifetime spectrum is obtained in the same manner as in the measurement of the average pore volume of the atomic-scale pores, the obtained spectrum is fitted with four components, and the average lifetime of the component having the longest lifetime is applied to the following equations and converted into the volume of the pores, to thereby determine the average pore volume of the nanoscale pores. Generally, the volume of pores having a volume exceeding 1 nm$^3$ in the silica particles, such as pores surrounded by a Si-O-Si structure, silanol groups, and/or alkoxy groups, can be determined from the obtained average pore volume of the nanoscale pores of the silica particles.

[Equation 3]

$$\tau = \left\{ \frac{3}{4} \times \frac{0.021}{R - r_0} + \lambda_T \right\}^{-1}$$

$$\left( r_0 = 0.57 \text{ nm}, \lambda_T = \frac{1}{142} \, ns^{-1} \right)$$

In these equations,

[Equation 4]

$$V = \frac{4}{3} \pi R^3$$

$\tau$ is the average lifetime of positrons, R is the average radius of nanoscale pores, $r_0$ is the correction value of the radius of the nanoscale pores, $\lambda_T$ is the annihilation rate of ortho-positronium in vacuum, and V is the average pore volume of the nanoscale pores.

The mechanical strength of the silica particles can be adjusted by the pore volume. From this viewpoint, the volume of pores having a diameter of 2 nm or less is preferably 0.0070 cm$^3$/g or less, more preferably 0.0060 cm$^3$/g or less, and even more preferably 0.0050 cm$^3$/g or less, as measured by the nitrogen gas adsorption method. In addition, from the viewpoint of maintaining the flexibility of the structure of the silica particles, the volume of pores having a diameter of 2 nm or less is preferably 0.0005 cm$^3$/g or more, more preferably 0.0010 cm$^3$/g or more, and even more preferably 0.0015 cm$^3$/g or more, as measured by the nitrogen gas adsorption method.

When the refractive index of the silica particles is large, the atomic density of the silica particles is high, and the mechanical strength is easily maintained. Therefore, the refractive index is preferably 1.390 or more, more preferably 1.400 or more, and even more preferably 1.410 or more. In addition, since the silica preferably maintains the amorphous structure, the refractive index is preferably 1.550 or less, more preferably 1.500 or less, and even more preferably 1.450 or less.

The refractive index of the silica particles is determined as follows: special grade 2-propanol and special grade toluene are added at different ratios to a container containing the silica particles, the supernatant is subjected to measurement with an Abbe refractometer when the silica particles in the container become transparent, and the refractive index measured at this time is used as the refractive index of the silica particles.

The silica particles are preferably amorphous. When the silica particles are amorphous, silanol groups are appropriately present on the surfaces of the silica particles, and in the step of polishing an object to be polished, a chemical action occurs between the silica particles and the object to be polished via the silanol groups, and thus polishing proceeds in a favorable manner.

The fact that the silica particles are amorphous can be confirmed by a halo pattern in wide-angle X-ray scattering measurement.

The silica particles have a metal impurity content of preferably 5 ppm or less, and more preferably 2 ppm or less.

When the metal impurity content of the silica particles is 5 ppm or less, in polishing of a silicon wafer of a semiconductor device, contamination due to metal impurities adhering to the surface of the object to be polished is reduced, and the impact on wafer properties due to such contamination is reduced, which is preferred. In addition, a deterioration in quality due to diffusion of metal impurities deposited on the surface of the object to be polished into the interior of the wafer and a deterioration in performance of a semiconductor device manufactured using such a wafer are reduced, and thus such a low metal impurity content is preferred.

Further, when the metal impurity content of the silica particles is 5 ppm or less, the polishing rate is less influenced by a change in the chemical properties (e.g., acidity) of the surface silanol groups caused by the occurrence of coordinate interaction between the acidic surface silanol groups and the metal impurities, or by a change in the steric environment (e.g., ease of aggregation of the silica particles) of the surfaces of the silica particles, and thus such a low metal impurity content is preferred.

The metal impurity content of the silica particles in the present specification is a value measured by high frequency inductively coupled plasma mass spectrometry (ICP-MS). Specifically, a test solution is prepared by accurately weighing a silica sol containing 0.4 g of silica particles, adding sulfuric acid and hydrofluoric acid thereto, heating, dissolving, and evaporating the mixture, and adding pure water to the remaining sulfuric acid droplets such that the total amount is exactly 10 g. The test solution is then subjected to measurement using a high-frequency inductively coupled plasma mass spectrometer. The target metals are sodium, potassium, iron, aluminum, calcium, magnesium, zinc, cobalt, chromium, copper, manganese, lead, titanium, silver, and nickel, and the total content of these metals is defined as the metal impurity content.

The metal impurity content of the silica particles can be set to 5 ppm or less by producing silica particles through hydrolysis reaction and condensation reaction using alkoxysilane as a main raw material.

In the silica particle production method involving deionizing an alkali silicate such as water glass, it is extremely difficult to reduce the metal impurity content of the silica particles to 5 ppm or less because sodium or the like derived from the raw material remains.

The silica particles have an average primary particle size of preferably from 10 nm to 100 nm, more preferably from 15 nm to 60 nm, and even more preferably from 30 nm to 50 nm. When the average primary particle size of the silica particles is 10 nm or more, a silica sol has excellent storage stability. In addition, when the average primary particle size of the silica particles is 100 nm or less, the surface roughness and scratches of a polished object, such as a silicon wafer, can be reduced, and sedimentation of the silica particles can be suppressed.

The average primary particle size of the silica particles is measured by the BET method. Specifically, the specific surface area of the silica particles is measured using an automatic specific surface area measuring device, and the average primary particle size is calculated using the following equation (2).

$$\text{Average primary particle size (nm)} = 6000/(\text{specific surface area (m}^2/\text{g)} \times \text{density (g/cm}^3)) \cdots (2)$$

The average primary particle size of the silica particles can be set to fall within a desired range by controlling the production conditions of the silica particles.

The silica particles have an average secondary particle size of preferably from 20 nm to 200 nm, more preferably from 30 nm to 100 nm, and even more preferably from 55 nm to 80 nm. When the average secondary particle size of the silica particles is 20 nm or more, the particles and the like can be easily removed during cleaning after polishing, and the silica sol has excellent storage stability. In addition, when the average secondary particle size of the silica particles is 200 nm or less, the surface roughness and scratches on a polished object such as a silicon wafer during polishing can be reduced, the particles and the like can be easily removed during cleaning after polishing, and sedimentation of the silica particles can be suppressed.

The average secondary particle size of the silica particles is measured by the DLS method. Specifically, the average secondary particle size is measured using a dynamic light scattering particle size measuring device.

The average secondary particle size of the silica particles can be set to fall within a desired range by controlling the production conditions of the silica particles.

The silica particles have a cv value of preferably from 10% to 50%, more preferably from 15% to 40%, and even more preferably from 20% to 35%. When the cv value of the silica particles is 10% or more, the polishing rate of an object to be polished, such as a silicon wafer, is excellent, and the productivity of a silicon wafer is excellent. In addition, when the cv value of the silica particles is 50% or less, the surface roughness and scratches on a polished object, such as a silicon wafer, during polishing can be reduced, and particles and the like can be easily removed during cleaning after polishing.

The cv value of the silica particles is determined by measuring the average secondary particle size of the silica particles using a dynamic light scattering particle size measuring device, and then using the following equation (3) to calculate the cv value.

$$\text{cv value} = (\text{standard deviation (nm)}/\text{average secondary particle size (nm)}) \times 100 \cdots (3)$$

The silica particles have an association ratio of preferably from 1.0 to 4.0, and more preferably from 1.1 to 3.0. When the association ratio of the silica particles is 1.0 or more, the polishing rate with respect to an object to be polished, such as a silicon wafer, is excellent, and the productivity of a silicon wafer is excellent. In addition, when the association ratio of the silica particles is 4.0 or less, the surface roughness and scratches on a polished object, such as a silicon wafer, during polishing can be reduced, and the aggregation of the silica particles can be suppressed.

The association ratio of the silica particles is calculated from the average primary particle size measured by the above-described measurement method and the average secondary particle size measured by the above-described measurement method using the following equation (4).

$$\text{Association ratio} = (\text{average secondary particle size})/(\text{average primary particle size}) \cdots (4)$$

From the viewpoints of low metal impurity content and excellent mechanical strength and storage stability, the silica particles of the present invention preferably contain an alkoxysilane condensate as a main component, more preferably contain a tetraalkoxysilane condensate as a main component, and even more preferably contain a tetramethoxysilane condensate as a main component. The main component refers to a component that accounts for 50 mass% or more per 100 mass% of all components constituting the silica particles.

In order to produce silica particles containing an alkoxysilane condensate as a main component, an alkoxysilane is preferably used as the main raw material. In order to produce silica particles containing a tetraalkoxysilane condensate as a main component, a tetraalkoxysilane is preferably used as the main raw material. In order to produce silica particles containing a tetramethoxysilane condensate as a main component, tetramethoxysilane is preferably used as the main raw material. The main raw material refers to a raw material that accounts for 50 mass% or more per 100 mass% of all the raw materials constituting the silica particles.

The silica particles of the present invention have a surface density of silanol group preferably from 1 silanol group $/nm^2$ to 8 silanol groups/$nm^2$, and more preferably from 4 silanol groups/$nm^2$ to 7 silanol groups/$nm^2$. When the surface silanol group density of the silica particles is 1 silanol group/$nm^2$ or more, the silica particles exhibit appropriate surface repulsion, and the silica sol has excellent dispersion stability. In addition, when the surface silanol group density of the silica particles is 8 silanol groups/$nm^2$ or less, the silica particles exhibit appropriate surface repulsion, and aggregation of the silica particles can be suppressed.

The surface silanol group density of the silica particles is measured by the Sears method. Specifically, measurement and calculation are carried out under the following conditions.

A silica sol equivalent to 1.5 g of silica particles is collected, and pure water is added to the silica sol to achieve a liquid volume of 90 mL. In a 25°C environment, a 0.1 mol/L aqueous hydrochloric acid solution is added until the pH reaches 3.6, and 30 g of sodium chloride is added thereto. Then, pure water is gradually added until the sodium chloride is completely dissolved, and pure water is further added until the total amount of a test solution becomes 150 mL, to thereby prepare a test solution.

The prepared test solution is charged into an automatic titrator, a 0.1 mol/L aqueous sodium hydroxide solution is added dropwise thereto, and a titration amount A (mL) of the 0.1 mol/L aqueous sodium hydroxide solution required to change the pH level from 4.0 to 9.0 is measured.

The consumption amount V (mL) of the 0.1 mol/L aqueous sodium hydroxide solution required to change the pH level from 4.0 to 9.0 per 1.5 g of the silica particles is calculated using the following equation (5), and the surface silanol group density $\rho$ (groups/$nm^2$) of the silica particles is calculated using the following equation (6).

$$V = (A \times f \times 100 \times 1.5)/(W \times C) \cdots (5)$$

A: Titration amount (mL) of the 0.1 mol/L aqueous sodium hydroxide solution required to change the pH level from 4.0 to 9.0 per 1.5 g of silica particles
F: Titer of the 0.1 mol/L aqueous sodium hydroxide solution used
C: Concentration (mass%) of the silica particles in the silica sol
W: Amount (g) of the sampled silica sol

$$\rho = (B \times NA)/(10^{18} \times M \times SBET) \cdots (6)$$

B: Amount (mol) of sodium hydroxide required to change the pH level from 4.0 to 9.0 per 1.5 g of the silica particles as calculated from V

NA: Avogadro's constant (molecules/mol)

M: Amount of silica particles (1.5 g)

SBET: Specific surface area ($m^2$/g) of the silica particles measured when the average primary particle size is calculated

Method for Producing Silica Particles

The silica particles of the present invention can be produced by a method including a step of subjecting a tetraalkoxysilane to hydrolysis reaction and condensation reaction at a pH of from 8 to 14. A method in which a tetraalkoxysilane-containing solution (B) and, if necessary, a solution (C) are added to a solution (A) containing water to hydrolyze and condense the tetraalkoxysilane is preferred, because when such a method is used, the hydrolysis reaction and condensation reaction can be easily controlled, the reaction rates of the hydrolysis reaction and condensation reaction can be increased, gelation of a dispersion of the silica particles can be prevented, and silica particles having a uniform particle size can be produced. The average pore volume of the atomic-scale pores of the silica particles and the average pore volume of the nanoscale pores of the silica particles can be set to fall within a desired range by controlling the production conditions of the silica particles such as pH, reaction temperature, reaction time, catalyst concentration, and raw material supply rate, and the pressurization and heat treatment conditions such as pressurizing pressure, heating temperature, and pressurization and heating time. For example, the average pore volume of the atomic-scale pores of the silica particles tends to increase in association with shortening of the reaction times of the hydrolysis reaction and condensation reaction of the tetraalkoxysilane, or in association with an increase in the temperature and pressure of the pressurization and heat treatment. Meanwhile, for example, the average pore volume of the nanoscale pores of the silica particles tends to decrease in association with an increase in the reaction temperatures of the hydrolysis reaction and condensation reaction of the tetraalkoxysilane, or in association with prolongation of the reaction times of the hydrolysis reaction and condensation reaction of the tetraalkoxysilane.

The solution (A) contains water.

The solution (A) preferably contains a solvent other than water because of the excellent dispersibility of the tetraalkoxysilane in the reaction solution.

Examples of the solvent other than water in the solution (A) include methanol, ethanol, propanol, isopropanol, and ethylene glycol. A single type of these solvents may be used alone, or two or more types thereof may be used in combination. Among these solvents, an alcohol is preferred, methanol or ethanol is more preferred, and methanol is even more preferred, because such an alcohol easily dissolves the tetraalkoxysilane, such an alcohol used in the hydrolysis reaction and condensation reaction is the same as that produced as a by-product, and such an alcohol provides excellent convenience for production.

The solution (A) preferably contains an alkali catalyst because the reaction rates of the hydrolysis reaction and condensation reaction of the tetraalkoxysilane can be increased.

Examples of the alkali catalyst in the solution (A) include ethylenediamine, diethylenetriamine, triethylenetetramine, ammonia, urea, ethanolamine, and tetramethylammonium hydroxide. A single type of these alkali catalysts may be used alone, or two or more types thereof may be used in combination. Among these alkali catalysts, ammonia is preferred because ammonia exhibits excellent catalytic action, easily controls the particle shape, can suppress the mixing-in of metal impurities, is highly volatile, and exhibits excellent removability after the hydrolysis reaction and the condensation reaction.

The concentration of water in the solution (A) is preferably from 3 mass% to 90 mass%, and more preferably from 5 mass% to 50 mass% per 100 mass% of the solution (A). When the concentration of water in the solution (A) is 3 mass% or more, the hydrolysis reaction rate of the tetraalkoxysilane is easily controlled. When the concentration of water in the solution (A) is 90 mass% or less, the hydrolysis reaction and the condensation reaction are well balanced, and the particle shape is easily controlled.

The concentration of the alkali catalyst in the solution (A) is preferably from 0.5 mass% to 2.0 mass%, and more preferably from 0.6 mass% to 1.5 mass% per 100 mass% of the solution (A). When the concentration of the alkali catalyst in the solution (A) is 0.5 mass% or more, aggregation of the silica particles is suppressed, and the silica particles exhibit excellent dispersion stability in the dispersion. In addition, when the concentration of the alkali catalyst in the solution (A) is 2.0 mass% or less, the reaction does not proceed excessively fast, and the reaction controllability is excellent.

The concentration of the solvent other than water in the solution (A) is preferably the concentration of the remainder besides water and the alkali catalyst.

The solution (B) contains a tetraalkoxysilane.

Examples of the tetraalkoxysilane in the solution (B) include tetramethoxysilane, tetraethoxysilane, tetrapropoxysilane, and tetraisopropoxysilane. A single type of these tetraalkoxysilanes may be used alone, or two or more types thereof may be used in combination. Among these tetraalkoxysilanes, tetramethoxysilane or tetraethoxysilane is preferred, and tetramethoxysilane is more preferred, because the hydrolysis reaction proceeds fast, unreacted substances do not easily remain, productivity is excellent, and a stable silica sol can be easily produced.

As the raw material of the silica particles, a raw material other than tetraalkoxysilane, such as an oligomeric condensate of a tetraalkoxysilane, may be used. However, in view of excellent reactivity, per 100 mass% of all the raw materials constituting the silica particles, preferably, the content of the tetraalkoxysilane is 50 mass% or more and the content of raw materials other than the tetraalkoxysilane is 50 mass% or less, and more preferably, the content of the tetraalkoxysilane is 90 mass% or more and the content of raw materials other than the tetraalkoxysilane is 10 mass% or less.

The solution (B) may contain only the tetraalkoxysilane without containing a solvent, but preferably contains a solvent because of the excellent dispersibility of the tetraalkoxysilane in the reaction solution.

Examples of the solvent in the solution (B) include methanol, ethanol, propanol, isopropanol, and ethylene glycol. A single type of these solvents may be used alone, or two or more types thereof may be used in combination. Among these solvents, an alcohol is preferred, methanol or ethanol is more preferred, and methanol is even more preferred, because such an alcohol used in the hydrolysis reaction and condensation reaction is the same as that produced as a by-product, and such an alcohol provides excellent convenience for production.

The concentration of the tetraalkoxysilane in the solution (B) is preferably from 60 mass% to 95 mass%, and more preferably from 70 mass% to 90 mass% per 100 mass% of the solution (B). When the concentration of the tetraalkoxysilane in the solution (B) is 60 mass% or more, the reaction solution is likely to be homogeneous. When the concentration of the tetraalkoxysilane in the solution (B) is 95 mass% or less, formation of a gel-like substance can be suppressed.

The concentration of the solvent in the solution (B) is preferably from 5 mass% to 40 mass%, and more preferably from 10 mass% to 30 mass% per 100 mass% of the solution (B). When the concentration of the solvent in the solution (B) is 5 mass% or more, formation of a gel-like substance can be suppressed. When the concentration of the solvent in the solution (B) is 40 mass% or less, the reaction solution is likely to be homogeneous.

The rate of addition of the solution (B) per hour per volume of the solution (A) is preferably from 0.02 kg/hour/L to 1.3 kg/hour/L, and more preferably from 0.05 kg/hour/L to 0.8 kg/hour/L. When the rate of addition of the solution (B) is 0.02 kg/hour/L or more, the productivity of the silica particles is excellent. When the rate of addition of the solution (B) is 1.3 kg/hour/L or less, formation of a gel-like substance can be suppressed.

The solution (C) contains water, and preferably further contains an alkali catalyst.

Examples of the alkali catalyst that can be contained in the solution (C) include ethylenediamine, diethylenetriamine, triethylenetetramine, ammonia, urea, ethanolamine, and tetramethylammonium hydroxide. A single type of these alkali catalysts may be used alone, or two or more types thereof may be used in combination. Among these alkali catalysts, ammonia is preferred because ammonia exhibits excellent catalytic action, easily controls the particle shape, can suppress a mixing-in of metal impurities, is highly volatile, and exhibits excellent removability after the hydrolysis reaction and the condensation reaction.

The solution (C) contains water as a solvent, and examples of the solvent other than water include methanol, ethanol, propanol, isopropanol, and ethylene glycol. A single type of the solvents other than water may be used alone, or two or more types thereof may be used in combination. Among the solvents of the solution (C), water alone or a combination of water and an alcohol is preferred, and water alone is more preferred, because the solvent used in the hydrolysis reaction and the condensation reaction is the same as that produced as a by-product, and the convenience in production is excellent.

The concentration of the alkali catalyst in the solution (C) is preferably from 0 mass% to 10 mass% per 100 mass% of the solution (C). The amount of the alkali catalyst in the solution (C) may be 0 mass%, that is, the alkali catalyst may not be contained. However, when the alkali catalyst is contained, the concentration thereof is preferably 0.5 mass% or more, and more preferably 1 mass% or more. When the concentration of the alkali catalyst in the solution (C) is 0.5 mass% or more, the concentration of the alkali catalyst in the reaction solution can be easily adjusted from the startup of the reaction to the completion of the reaction. Moreover, from the viewpoint of reducing variation in the concentration of the alkali catalyst in the reaction solution, the concentration of the alkali catalyst in the solution (C) is preferably 10 mass% or less, and more preferably 6 mass% or less.

The concentration of water in the solution (C) is preferably from 90 mass% to 100 mass% per 100 mass% of the solution (C). The concentration of water in the solution (C) may be 100 mass%, that is, the solution (C) may be composed only of water, but when an additional component is contained, the concentration of water is preferably 99.5 mass% or less, and more preferably 99 mass% or less. From the viewpoint of reducing variation in the concentration of the alkali catalyst in the reaction solution, the concentration of water in the solution (C) is preferably 90 mass% or more, and more preferably 94 mass% or more. When the concentration of water in the solution (C) is 99.5 mass% or less, the concentration of the alkali catalyst in the reaction solution can be easily adjusted from the startup of the reaction to the completion of the reaction.

The concentration of the solvent other than water in the solution (C) is preferably the concentration of the remainder besides water and the alkali catalyst.

The solution (B) and the solution (C) are preferably added into the solution (A). In a case where the use of a highly volatile alkali catalyst such as ammonia is desired, and in a case where the progress of a hydrolysis reaction and a condensation reaction at a high reaction temperature is desired, when the solutions (B) and (C) are added into the solution (A), the miscibility of the various components in the reaction solution can be increased, abnormal reactions in air can be suppressed, and the particle shape can be easily controlled. Adding into the solution means adding at a level equal to or lower than the liquid surface. The solution (B) and the solution (C) can be added into the solution (A) by setting the supply outlet of the solution (B) and the supply outlet of the solution (C) at a level equal to or lower than the liquid surface of the solution (A).

The addition timing of the solution (B) and addition timing of the solution (C) to the solution (A) may be the same or different such as alternately adding the solutions (B) and (C), but the addition timings are preferably the same because the reaction composition varies little and the operation does not become complicated.

The pH in the step of subjecting the tetraalkoxysilane to the hydrolysis reaction and the condensation reaction is from 8.0 to 14, preferably from 8.2 to 13, and more preferably from 8.5 to 12. When the pH in the above-mentioned step is 8.0 or higher, the reaction rates of the hydrolysis reaction and the condensation reaction are excellent, and aggregation of the silica particles can be suppressed. When the pH in the above-mentioned step is 14 or lower, the shape of the silica particles is easily controlled, and the silica particles have excellent surface smoothness.

The method for producing the silica particles of the present invention preferably includes a step of carrying out a hydrolysis reaction and a condensation reaction of an alkoxysilane for 600 minutes or less, more preferably 400 minutes or less, and even more preferably 170 minutes or less. When the reaction time is 600 minutes or less, the growth rate of the silica particles is appropriately low, and thus a reaction in which dangling bonds of a silicon atom are directly bonded to dangling bonds of an adjacent silicon atom is suppressed. Therefore, the distortion of the siloxane network of the silica particles can be reduced, and the average pore volume of the atomic-scale pores of the silica particles can be adjusted to fall within a suitable range, which is preferred. When the reaction time is 30 minutes or longer, particle growth does not proceed too fast, and the particle size and the particle shape are well controlled.

The concentration of water in the reaction system of the hydrolysis reaction and the condensation reaction is preferably maintained at from 3 mass% to 90 mass%, more preferably from 5 mass% to 30 mass%, and even more preferably from 6 mass% to 25 mass%, per 100 mass% of the total amount in the reaction system. When the concentration of water in the reaction system is 3 mass% or more, the hydrolysis reaction rate of the tetraalkoxysilane is easily controlled. When the concentration of water in the reaction system is 90 mass% or less, the hydrolysis reaction and the condensation reaction are well balanced, and the particle shape is easily controlled.

The concentration of the alkali catalyst in the reaction system of the hydrolysis reaction and the condensation reaction is preferably maintained at from 0.5 mass% to 2.0 mass% and more preferably from 0.6 mass% to 1.5 mass% per 100 mass% of the total amount in the reaction system. When the concentration of the alkali catalyst in the reaction system is 0.5 mass% or more, aggregation of the silica particles is suppressed, and the silica particles exhibit excellent dispersion stability in the dispersion. When the concentration of the alkali catalyst in the reaction system is 2.0 mass% or less, the reaction does not proceed excessively fast, and the reaction controllability is excellent.

The method for producing the silica particles preferably further includes the following step (1) because when such a step is performed, unnecessary components can be removed and necessary components can be added.

Step (1): concentrating the produced dispersion of silica particles and adding a dispersion medium.

In step (1), either concentration of the dispersion of the silica particles or addition of the dispersion medium may be implemented first.

The method for concentrating the dispersion of silica particles is not particularly limited, and examples thereof include a thermal concentration method and a membrane concentration method.

In order to concentrate the dispersion of silica particles by a thermal concentration method, the dispersion may be heated and concentrated at normal pressure or reduced pressure.

In order to concentrate the dispersion of silica particles by a membrane concentration method, membrane separation is preferably performed by an ultrafiltration method. Here, the main purpose of the ultrafiltration method is to remove unnecessary components such as intermediate products. The molecular weight cut-off of the ultrafiltration membrane used herein is selected such that the intermediate product in the dispersion can be separated by filtration and removed according to the size of the intermediate product.

Examples of the material of the ultrafiltration membrane include polysulfone, polyacrylonitrile, sintered metal, ceramic, and carbon. Examples of the form of the ultrafiltration membrane include a spiral form, a tubular form, and a hollow fiber form.

Examples of the dispersion medium added to the dispersion of silica particles include water, methanol, ethanol, propanol, isopropanol, and ethylene glycol. A single type of these dispersion media may be used alone, or two or more types thereof may be used in combination. Among these dispersion media, water or an alcohol is preferred, and water is more preferred because of excellent affinity with the silica particles.

The method for producing the silica particles preferably further includes the following step (2) because when such a step is performed, the degree of condensation of the silica particles can be increased.

Step (2): subjecting the dispersion of the silica particles produced in the step (1) to a pressurization and heat treatment.

The pressure of the pressurization and heat treatment is preferably from 0.10 MPa to 2.3 MPa, and more preferably from 0.12 MPa to 2.0 MPa. When the pressurization and heat treatment is carried out at a pressure of 0.10 MPa or higher, the degree of condensation of the silica particles can be increased. When the pressurization and heat treatment is carried out at a pressure of 2.3 MPa or lower, the silica particles can be produced without significantly changing the average primary particle size, the average secondary particle size, the cv value, or the association ratio, and the silica sol has excellent dispersion stability.

Pressurization may be carried out by heating, in a tightly sealed state, the dispersion of the silica particles to a temperature equal to or higher than the boiling point of the dispersion medium. When the aqueous dispersion of silica particles is heated in a tightly sealed state to 100°C or higher, the pressure reaches the saturated water vapor pressure at the temperature.

The temperature of the pressurization and heat treatment is preferably from 100°C to 220°C, and more preferably from 110°C to 180°C. When the temperature of the pressurization and heat treatment is 100°C or higher, the degree of condensation of the silica particles can be increased. When the temperature of the pressurization and heat treatment is 220°C or lower, the silica particles can be produced without significantly changing the average primary particle size, the average secondary particle size, the cv value, or the association ratio, and the silica sol has excellent dispersion stability.

The time of the pressurization and heat treatment is preferably from 0.25 hours to 10 hours, and more preferably from 0.5 hours to 8 hours. When the time of the pressurization and heat treatment is 0.25 hours or longer, the degree of condensation of the silica particles can be increased. When the time of the pressurization and heat treatment is 10 hours or shorter, the silica particles can be produced without significantly changing the average primary particle size, the average secondary particle size, the cv value, or the association ratio, and the silica sol has excellent dispersion stability.

The pressurization and heat treatment is more preferably carried out in an aqueous dispersion because the degree of condensation of the silica particles can be increased without significantly changing the average primary particle size, the average secondary particle size, the cv value, or the association ratio.

The pH when the pressurization and heat treatment is carried out in the aqueous dispersion is preferably from 6.0 to 8.0, and more preferably from 6.5 to 7.8. When the pH is 6.0 or higher while the pressurization and heat treatment is carried out in the aqueous dispersion, gelation of the silica sol can be suppressed. When the pH is 8.0 or lower while the pressurization and heat treatment is carried out in the aqueous dispersion, the degree of condensation of the silica particles can be increased without significantly changing the average primary particle size, the average secondary particle size, the cv value, or the association ratio.

Silica Sol

The silica sol of the present invention contains the silica particles of the present invention.

As the silica sol, the dispersion of the silica particles of the present invention may be used as is, or the silica sol may be produced by removing unnecessary components among the components in the dispersion of the silica particles of the present invention, or adding necessary components.

The silica sol of the present invention preferably contains the silica particles and a dispersion medium.

Examples of the dispersion medium in the silica sol include water, methanol, ethanol, propanol, isopropanol, and ethylene glycol. A single type of these dispersion media in the silica sol may be used alone, or two or more types thereof may be used in combination. Among these dispersion media in the silica sol, water or an alcohol is preferred, and water is more preferred, because of the excellent affinity with the silica particles.

The content of the silica particles in the silica sol is preferably from 3 mass% to 50 mass%, more preferably from 4 mass% to 40 mass%, and even more preferably from 5 mass% to 30 mass% per 100 mass% of the total amount of the silica sol. When the content of the silica particles in the silica sol is 3 mass% or more, the polishing rate with respect to an object to be polished, such as a silicon wafer, is excellent. When the content of the silica particles in the silica sol is 50 mass% or less, aggregation of the silica particles in the silica sol or in a polishing composition can be suppressed, and the silica sol or the polishing composition has excellent storage stability.

The content of the dispersion medium in the silica sol is preferably from 50 mass% to 97 mass%, more preferably from 60 mass% to 96 mass%, and even more preferably from 70 mass% to 95 mass% per 100 mass% of the total amount of the silica sol. When the content of the dispersion medium in the silica sol is 50 mass% or more, aggregation of the silica particles in the silica sol or in a polishing composition can be suppressed, and the silica sol or the polishing composition has excellent storage stability. When the content of the dispersion medium in the silica sol is 97 mass% or less, the polishing rate with respect to an object to be polished, such as a silicon wafer, is excellent.

The content of the silica particles or the content of the dispersion medium in the silica sol can be set to fall within a desired range by removing unnecessary components among the components in the produced dispersion of the silica particles and by adding necessary components.

The silica sol may contain an additional component other than the silica particles and the dispersion medium as necessary, as long as the performance of the silica sol is not impaired. Examples of the additional component include an oxidant, a preservative, an antifungal agent, a pH adjuster, a pH buffer, a surfactant, a chelating agent, and an antibacterial biocide.

In particular, the silica sol preferably contains an antibacterial biocide because addition thereof results in excellent storage stability of the silica sol.

Examples of the antibacterial biocide include hydrogen peroxide, ammonia, quaternary ammonium hydroxides, quaternary ammonium salts, ethylenediamine, glutaraldehyde, methyl p-hydroxybenzoate, and sodium chlorite. A single type of these antibacterial biocides may be used alone, or two or more types thereof may be used in combination. Among these antibacterial biocides, hydrogen peroxide is preferred because of its excellent affinity with the silica sol.

The antibacterial biocides also include those commonly referred to as bactericides.

The content of the antibacterial biocide in the silica sol is preferably from 0.0001 mass% to 10 mass%, and more preferably from 0.001 mass% to 1 mass% per 100 mass% of the total amount of the silica sol. When the content of the antibacterial biocide in the silica sol is 0.0001 mass% or more, the silica sol has excellent storage stability. When the content of the antibacterial biocide in the silica sol is 10 mass% or less, the inherent performance of the silica sol is not impaired.

The pH of the silica sol is preferably from 6.0 to 8.0, and more preferably from 6.5 to 7.8. When the pH of the silica sol is 6.0 or higher, the dispersion stability is excellent, and aggregation of the silica particles can be suppressed. When the pH of the silica sol is 8.0 or lower, dissolution of the silica particles is prevented, and the storage stability remains excellent over a long period of time.

The pH of the silica sol can be set to fall within a desired range by adding a pH adjuster.

Polishing Composition

The polishing composition of the present invention contains the silica sol of the present invention.

The polishing composition of the present invention preferably contains a water-soluble polymer in addition to the silica sol of the present invention.

The water-soluble polymer enhances the wettability of the polishing composition with respect to an object to be polished, such as a silicon wafer. The water-soluble polymer is preferably a polymer having a functional group with a high affinity for water. This functional group with a high affinity for water also has a high affinity for the surface silanol groups of the silica particles, and thus the silica particles and the water-soluble polymer are stably dispersed in closer vicinity to each other in the polishing composition. Therefore, when an object to be polished such as a silicon wafer is polished, the effects of the silica particles and the water-soluble polymer function synergistically.

Examples of the water-soluble polymer include a cellulose derivative, polyvinyl alcohol, polyvinylpyrrolidone, a copolymer having a polyvinylpyrrolidone skeleton, and a polymer having a polyoxyalkylene structure.

Examples of the cellulose derivative include hydroxyethyl cellulose, hydrolyzed hydroxyethyl cellulose, hydroxypropyl cellulose, hydroxyethylmethyl cellulose, hydroxypropylmethyl cellulose, methyl cellulose, ethyl cellulose, ethylhydroxyethyl cellulose, and carboxymethyl cellulose.

Examples of the copolymer having a polyvinylpyrrolidone skeleton include a graft copolymer of polyvinyl alcohol and polyvinylpyrrolidone.

Examples of the polymer having a polyoxyalkylene structure include polyoxyethylene, polyoxypropylene, and a copolymer of ethylene oxide and propylene oxide.

A single type of these water-soluble polymers may be used alone, or two or more types thereof may be used in combination. Among these water-soluble polymers, a cellulose derivative is preferred, and hydroxyethyl cellulose is more preferred, because such a cellulose derivative has a high affinity for the surface silanol groups of the silica particles and acts synergistically to impart good hydrophilicity to the surface of an object to be polished.

The water-soluble polymer has a mass average molecular weight of preferably from 1000 to 3000000, more preferably from 5000 to 2000000, and even more preferably from 10000 to 1000000. When the mass average molecular weight of the water-soluble polymer is 1000 or more, the hydrophilicity of the polishing composition is improved. When the mass average molecular weight of the water-soluble polymer is 3000000 or less, the affinity for the silica sol is excellent, and the polishing rate with respect to an object to be polished such as a silicon wafer is excellent.

The mass average molecular weight of the water-soluble polymer is measured in terms of polyethyleneoxide by size exclusion chromatography using a 0.1 mol/L NaCl solution as a mobile phase.

The content of the water-soluble polymer in the polishing composition is preferably from 0.02 mass% to 10 mass%, and more preferably from 0.05 mass% to 5 mass%, per 100 mass% of the total amount of the polishing composition. When the content of the water-soluble polymer in the polishing composition is 0.02 mass% or more, the hydrophilicity of the polishing composition is improved. When the content of the water-soluble polymer in the polishing composition is 10 mass% or less, aggregation of the silica particles can be suppressed during preparation of the polishing composition.

The polishing composition of the present invention may contain, in addition to the silica sol and the water-soluble polymer, an additional component as necessary, as long as the performance of the polishing composition is not impaired. Examples of the additional component include a basic compound, a polishing accelerator, a surfactant, a hydrophilic compound, a preservative, an antifungal agent, a pH adjuster, a pH buffer, a surfactant, a chelating agent, and an antibacterial biocide.

In particular, a basic compound is preferably contained in the polishing composition because chemical polishing (chemical etching) can be carried out by applying a chemical action to the surface of an object to be polished such as a silicon wafer, and the polishing rate of the object to be polished, such as a silicon wafer, can be improved by a synergistic effect of the basic compound with the surface silanol groups of the silica particles.

Examples of the basic compound include organic basic compounds, alkali metal hydroxides, alkali metal hydrogen carbonates, alkali metal carbonates, and ammonia. A single type of these basic compounds may be used alone, or two or more types thereof may be used in combination. Among these basic compounds, ammonia, tetramethylammonium hydroxide, tetraethylammonium hydroxide, ammonium hydrogen carbonate, or ammonium carbonate is preferred, ammonia, tetramethylammonium hydroxide, or tetraethylammonium hydroxide is more preferred, and ammonia is even more preferred, because of high water solubility and excellent affinity for the silica particles and the water-soluble polymer.

The content of the basic compound in the polishing composition is preferably from 0.001 mass% to 5 mass%, and more preferably from 0.01 mass% to 3 mass%, per 100 mass% of the total amount of the polishing composition. When the content of the basic compound in the polishing composition is 0.001 mass% or more, the polishing rate of an object to be polished such as a silicon wafer can be improved. When the content of the basic compound in the polishing composition is 5 mass% or less, the polishing composition has excellent stability.

The pH of the polishing composition is preferably from 8.0 to 12.0, and more from preferably 9.0 to 11.0. When the pH of the polishing composition is 8.0 or higher, aggregation of the silica particles in the polishing composition can be suppressed, and the polishing composition has excellent dispersion stability. When the pH of the polishing composition is 12.0 or lower, dissolution of the silica particles can be suppressed, and the polishing composition has excellent stability.

The pH of the polishing composition can be set to fall within a desired range by adding a pH adjuster.

The polishing composition is produced by mixing the silica sol of the present invention, the water-soluble polymer, and, if necessary, an additional component. In consideration of storage and transport, the polishing composition may be initially prepared at a high concentration and then diluted with water or the like immediately before polishing.

Polishing Method

The polishing method of the present invention is a method of polishing using a polishing composition containing the silica sol of the present invention.

The polishing composition used is preferably the above-mentioned polishing composition.

Specific examples of the polishing method include a method in which the surface of a silicon wafer is pressed against a polishing pad, and the polishing composition of the present invention is dropped onto the polishing pad to polish the surface of the silicon wafer.

Method for Producing Semiconductor Wafer

The method for producing a semiconductor wafer of the present invention is a method including a step of polishing using the polishing composition of the present invention, and the specific polishing composition and polishing method are as described above.

Examples of the semiconductor wafer include a silicon wafer and a compound semiconductor wafer.

Method for Producing Semiconductor Device

The method for producing a semiconductor device of the present invention is a method including a step of polishing using the polishing composition of the present invention, and the specific polishing composition and polishing method are as described above.

Other examples of the polishing target include metals such as Si, Cu, W, Ti, Cr, Co, Zr, Hf, Mo, Ta, Ru, Au, Pt, Ag, Al, and Ni; metal compounds such as oxides, nitrides, and silicides of the above-mentioned metals; and intermetallic compounds. The silica particles of the present invention and the silica sol of the present invention can be suitably used for metals and metal oxides among these polishing targets, and can be particularly suitably used for metal oxides.

Applications

The silica particles of the present invention and the silica sol of the present invention can be suitably used in polishing applications including, for example, polishing of semiconductor materials such as silicon wafers, polishing of electronic materials such as hard disk substrates, polishing (chemical mechanical polishing) in a planarization step during production of an integrated circuit, polishing of synthetic quartz glass substrates used in photomasks and liquid crystals, and polishing of magnetic disk substrates. In particular, the silica particles and the silica sol can be suitably used for polishing of silicon wafers and for chemical mechanical polishing.

As described above, the following aspects are disclosed in the present specification.

<1>
Silica particles having an average pore volume of atomic-scale pores of 0.35 $nm^3$ or more as measured by positron annihilation spectroscopy.

<2>
The silica particles according to <1>, wherein the silica particles have an average pore volume of atomic-scale pores of 0.40 $nm^3$ or more as measured by positron annihilation spectroscopy.

<3>
The silica particles according to <1> or <2>, wherein the silica particles have an average pore volume of atomic-scale pores of 1.0 $nm^3$ or less as measured by positron annihilation spectroscopy.

<4>
The silica particles according to any one of <1> to <3>, wherein the silica particles have an average pore volume of atomic-scale pores of 0.80 $nm^3$ or less as measured by positron annihilation spectroscopy.

<5>
The silica particles according to any one of <1> to <4>, wherein the silica particles have an average pore volume of nanoscale pores of 5.4 $nm^3$ or less as measured by positron annihilation spectroscopy.

<6>
The silica particles according to any one of <1> to <5>, wherein the silica particles have a volume of pores having a diameter of 2 nm or less of 0.0070 $cm^3$/g or less as measured by a nitrogen gas adsorption method.

<7>
The silica particles according to any one of <1> to <6>, wherein the silica particles have a refractive index of 1.390 or more.

<8>
The silica particles according to any one of <1> to <7>, wherein a metal impurity content is 5 ppm or less.

<9>
The silica particles according to any one of <1> to <8>, the silica particles contain a tetraalkoxysilane condensate as a main component.

<10>
A method for producing the silica particles described in any one of <1> to <9>, the method including carrying out a hydrolysis reaction and a condensation reaction of an alkoxysilane for 600 minutes or less.

<11>
A silica sol containing the silica particles described in any one of <1> to <9>.

<12>
A polishing composition containing the silica sol described in <11>.

<13>
A polishing method including polishing by using the polishing composition described in <12>.

<14>
A method for producing a semiconductor wafer, the method including polishing by using the polishing composition described in <12>.

<15>
A method for producing a semiconductor device, the method including polishing by using the polishing composition described in <12>.

Examples

The present invention will next be described in more detail by way of Examples, but the present invention is not limited to the description of the following Examples without departing from the gist of the invention.

Measurement of Average Pore Volume of Nanoscale Pores and Average Pore Volume of Atomic-Scale Pores

A positron lifetime spectrum was obtained by the following procedure using a positron beam lifetime spectrometer (National Institute of Advanced Industrial Science and Technology). A dry powder of silica particles was obtained from a dispersion of silica particles produced in Examples and Comparative Examples. The dry powder of silica particles was placed in a sample holder. The dry powder of silica particles was then irradiated with positrons in a vacuum of $4 \times 10^{-4}$ Pa at 20°C, and the time difference between the irradiation of positrons and the detection of $\gamma$-rays associated with the annihilation of the positrons was measured to obtain a positron lifetime spectrum. The incident energy of positrons was 10 keV.

The obtained positron lifetime spectrum was fitted with a linear sum of four exponential components to determine an average positron lifetime of each component. Among the four components, the two components having shorter lifetimes were components not derived from the sample. Among the remaining two components, one having the shorter lifetime was a component derived from atomic-scale pores, and the other was a component derived from nanoscale pores.

The average positron lifetime was converted into an average pore volume using the following equations.

Atomic-Scale Pores

[Equation 5]

$$\tau = 0.5 \left\{ 1 - \frac{R}{R + \Delta R} + \frac{1}{2\pi} \sin\left(\frac{2\pi R}{R + \Delta R}\right) \right\}^{-1}$$
$$(\Delta R = 0.165 \text{ nm})$$

In these equations,

[Equation 6]

$$V = \frac{4}{3}\pi R^3$$

$\tau$ is the average lifetime of positrons, R is the average radius of atomic-scale pores, $\Delta$R is the correction value of the radius of the atomic-scale pores, and V is the average pore volume of the atomic-scale pores.

Nanoscale Pores

[Equation 7]

$$\tau = \left\{ \frac{3}{4} \times \frac{0.021}{R - r_0} + \lambda_T \right\}^{-1}$$

$$\left( r_0 = 0.57 \text{ nm}, \lambda_T = \frac{1}{142} \text{ ns}^{-1} \right)$$

In these equations,

[Equation 8]

$$V = \frac{4}{3} \pi R^3$$

$\tau$ is the average lifetime of positrons, R is the average radius of nanoscale pores, $r_0$ is the correction value of the radius of the nanoscale pores, $\lambda_T$ is the annihilation rate of ortho-positronium in vacuum, and V is the average pore volume of the nanoscale pores.

Measurement of Refractive Index

A dry powder of silica particles was obtained from a dispersion of silica particles produced in Examples and Comparative Examples. 0.1 g of the dry powder of silica particles was placed in a 10 mL glass bottle, and special grade 2-propanol and special grade toluene were added at different ratios to the glass bottle. When the powder in the glass bottle became transparent, the supernatant was subjected to measurement with an Abbe refractometer "RX-7000$\alpha$" (model name, Atago Co., Ltd.) to determine the refractive index of the silica particles.

Measurement of Average Primary Particle Size

Each of the silica particle dispersions produced in Examples and Comparative Examples was dried at 150°C, the specific surface area of the silica particles was measured using an automatic specific surface area measuring device "BELSORP-MR1" (model name, MicrotracBEL Corp.), and the average primary particle size was calculated using the following equation (2) with the density being 2.2 g/cm$^3$.

Average primary particle size (nm) = 6000/(specific surface area (m$^2$/g) × density (g/cm$^3$)) (2)

Measurement of Average Secondary Particle Size

The average secondary particle size of the silica particles of each of the silica particle dispersions produced in Examples and Comparative Examples was measured using a dynamic light scattering particle size measuring device "Zetasizer Nano ZS" (model name, Malvern Panalytical Ltd.).

Measurement of Volume of Pores with Diameter of 2 nm or Less by Nitrogen Gas Adsorption Method

Each of the silica particle dispersions produced in Examples and Comparative Examples was dried at 300°C, and the isotherm of adsorption of nitrogen gas on the silica particles was measured using a pore distribution analyzer "Nova-touch" (model name, Anton Paar GmbH) and analyzed using the BJH method, to determine the volume of pores having a diameter of 2 nm or less.

Mechanical Strength

The silica particles produced in Examples and Comparative Examples were evaluated for whether they have a mechanical strength suitable for polishing a substrate having a metal oxide film on the surface according to the following indices.

A: Mechanical strength is assumed to be very suitable for polishing.
B: Mechanical strength is assumed to be suitable for polishing.
C: Mechanical strength is assumed to be unsuitable for polishing.

Storage Stability

The silica particles produced in Examples and Comparative Examples were evaluated for storage stability according to the following indices.

A: Storage stability is assumed to be very excellent.
B: Storage stability is assumed to be excellent.
C: Storage stability is assumed to be poor.

Example 1

A solution (B) was prepared by mixing tetramethoxysilane and methanol at 5.7:1 (mass ratio), and a solution (C) of 6.6 mass% aqueous ammonia solution was prepared. A reaction vessel equipped with a thermometer, a stirrer, a supply tube, and a distillation line was charged with a solution (A) prepared in advance by mixing methanol, pure water, and ammonia. The concentration of water in the solution (A) was 15 mass%, and the concentration of ammonia in the solution (A) was 2.4 mass%.

While the temperature of the reaction solution was maintained at 50°C, 63.6 parts by volume of the solution (B) and 24.6 parts by volume of the solution (C) were each added to 100 parts by volume of the solution (A) at a constant rate over 153 minutes, to produce a dispersion of silica particles. Methanol and ammonia were removed from the produced dispersion of silica particles by increasing the temperature while adjusting the liquid amount by adding pure water such that the content of the silica particles was approximately 20 mass%, to thereby produce a silica particle dispersion containing silica particles in an amount of approximately 20 mass%.

Example 2

The silica particle dispersion produced in Example 1 was sealed in an autoclave, heated, and maintained at 140°C for 2 hours to produce a silica particle dispersion subjected to pressurization and heat treatment.

Comparative Example 1

A silica particle dispersion "PL-3" available from Fuso Chemical Co., Ltd. was used in Comparative Example.

The evaluation results of the silica particles of the Examples and Comparative Examples described above are shown in Tables 1 and 2.

Table 1

| | Reaction Temperature [°C] | Reaction Time [min] | Pressurization and heat treatment Temperature [°C] and Time [h]* | Average Pore Volume [nm³] of Nanoscale Pores | Average Pore Volume [nm³] of Atomic-Scale Pores | Refractive Index | Average Primary Particle Size [nm] | Average Secondary Particle Size [nm] | Mechanical Strength | Storage Stability |
|---|---|---|---|---|---|---|---|---|---|---|
| Example 1 | 50 | 153 | - | 2.98 | 0.44 | 1.413 | 42.8 | 69.4 | A | A |
| Example 2 | 50 | 153 | 140 / 2 | 3.89 | 0.45 | 1.406 | 44.9 | 71.5 | A | A |
| Comparative Example 1 | - | - | - | 5.53 | 0.32 | 1.383 | 36.7 | 68.6 | C | C |

*Upper row: temperature [°C], lower row: time [h]

Table 2

| | Volume [cm$^3$/g] of Pores with Diameter of 2 nm or Less as Measured by Nitrogen Gas Adsorption Method |
|---|---|
| Example 1 | 0.0041 |
| Example 2 | 0.0018 |

As is clear from Table 1, in comparison to the silica particles produced in Comparative Example 1, the silica particles produced in Example 1 exhibit a large average pore volume of atomic-scale pores and a large refractive index even though the particle size remains mostly unchanged. Since the average pore volume of the atomic-scale pores is in an appropriate range, it is construed that the distortion of the siloxane network is reduced in the silica particles produced in Example 1. In the silica particles of Example 2 produced by subjecting the silica particles of Example 1 to the pressurization and heat treatment, the atomic-scale pores are further increased in size. Thus, it is construed that the distortion of the siloxane network is further reduced. Accordingly, the silica particles produced in Examples 1 and 2 have improved mechanical strength and storage stability. Furthermore, in a step of polishing an object to be polished using a polishing composition containing the silica particles produced in Examples 1 and 2, the silica particles are less likely to be broken.

In addition, as shown in Table 2, the pore volume of the silica produced in Examples 1 and 2 with a diameter of 2 nm or less as measured by the nitrogen gas adsorption method is in an appropriate range. From these results, it is construed that the number of pores that can become starting points of fracture is small in the silica, and thus the mechanical strength of the silica of Examples 1 and 2 is improved.

Therefore, by using a silica sol and a polishing composition containing the silica particles of Examples 1 and 2, an object to be polished can be effectively polished without damaging the object, the silica particles can be easily removed after polishing, and a high-quality polished product can be produced with good productivity.

Various embodiments have been described above, but the present invention is of course not limited to such embodiments. Moreover, it would be apparent to a person skilled in the art that various changes and modifications can be made within the scope of the claims, and it would be understood that such changes and modifications would naturally fall within the technical scope of the present invention. In addition, the constituent elements in the above-described embodiments may be arbitrarily combined within a scope that does not depart from the spirit of the invention.

The present application is based on JP 2022-099053 filed on June 20, 2022, the content of which is incorporated herein by reference.

Industrial Applicability

The silica particles of the present invention and the silica sol of the present invention can be suitably used in polishing applications. For example, the silica particles and the silica sol can be used for polishing a semiconductor material such as a silicon wafer, polishing an electronic material such as a hard disk substrate, polishing (chemical mechanical polishing) in a planarization step during production of an integrated circuit, polishing a synthetic quartz glass substrate used in a photomask or liquid crystal, and polishing a magnetic disk substrate. **In** particular, the silica particles and silica sol of the present invention can be suitably used in chemical mechanical polishing of a silicon wafer.

**Claims**

1. Silica particles wherein an average pore volume of atomic-scale pores as measured by positron annihilation spectroscopy is 0.35 nm$^3$ or more.

2. The silica particles according to claim 1, wherein the average pore volume of atomic-scale pores as measured by positron annihilation spectroscopy is 0.40 nm$^3$ or more.

3. The silica particles according to claim 1, wherein the average pore volume of atomic-scale pores as measured by positron annihilation spectroscopy is 1.0 nm$^3$ or less.

4. The silica particles according to claim 1, wherein an average pore volume of atomic-scale pores as measured by positron annihilation spectroscopy is 0.80 nm$^3$ or less.

5. The silica particles according to claim 1, wherein the average pore volume of nanoscale pores as measured by positron annihilation spectroscopy is 5.4 nm$^3$ or less.

6. The silica particles according to claim 1, wherein a volume of pores having a diameter of 2 nm or less as measured by a nitrogen gas adsorption method is 0.0070 cm$^3$/g or less.

7. The silica particles according to claim 1, wherein a refractive index is 1.390 or more.

8. The silica particles according to claim 1, wherein a metal impurity content is 5 ppm or less.

9. The silica particles according to claim 1, wherein the silica particles comprise a tetraalkoxysilane condensate as a main component.

10. A method for producing the silica particles described in any one of claims 1 to 9, the method comprising carrying out a hydrolysis reaction and a condensation reaction of an alkoxysilane for 600 minutes or less.

11. A silica sol comprising the silica particles described in any one of claims 1 to 9.

12. A polishing composition comprising the silica sol described in claim 11.

13. A polishing method comprising polishing by using the polishing composition described in claim 12.

14. A method for producing a semiconductor wafer, the method comprising polishing by using the polishing composition described in claim 12.

15. A method for producing a semiconductor device, the method comprising polishing by using the polishing composition described in claim 12.

## INTERNATIONAL SEARCH REPORT

International application No.

**PCT/JP2023/022446**

### A. CLASSIFICATION OF SUBJECT MATTER

*C01B 33/145*(2006.01)i; *B24B 37/00*(2012.01)i; *C01B 33/18*(2006.01)i; *H01L 21/304*(2006.01)i
FI: C01B33/145; B24B37/00 H; C01B33/18 Z; H01L21/304 622B; H01L21/304 622D

According to International Patent Classification (IPC) or to both national classification and IPC

### B. FIELDS SEARCHED

Minimum documentation searched (classification system followed by classification symbols)

C01B33/00-33/193; B24B37/00; C01B33/18; H01L21/304

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JST7580/JSTChina (JDreamIII)

### C. DOCUMENTS CONSIDERED TO BE RELEVANT

| Category* | Citation of document, with indication, where appropriate, of the relevant passages | Relevant to claim No. |
|---|---|---|
| X | JP 2021-116225 A (MITSUBISHI CHEM CORP) 10 August 2021 (2021-08-10)<br>examples, claims, paragraphs [0001], [0007]-[0047], [0061], [0076]-[0093] | 1-15 |
| X | WO 2021/153502 A1 (MITSUBISHI CHEM CORP) 05 August 2021 (2021-08-05)<br>examples, claims, paragraphs [0001], [0012]-[0105] | 1-15 |
| X | JP 2021-147267 A (MITSUBISHI CHEM CORP) 27 September 2021 (2021-09-27)<br>examples, claims, paragraphs [0001], [0006]-[0011], [0014]-[0046], [0065]-[0091], table 1 | 1-15 |
| X | KAJCSOS, Zs. On the peculiarities of positron annihilation features in silicalite-1 and Y-zeolites. Radiation Physics and Chemistry. June 2000, vol. 58, no. 5-6, pp. 709-714, DOI: 10.1016/S0969-806X(00)00244-9<br>abstract, p. 710, left column, 2nd paragraph to right column, 2nd paragraph, right column, 4th paragraph, p. 711, left column, 3rd paragraph, p. 713, right column, 2nd paragraph to p. 714, left column, 2nd paragraph, table 1 | 1-5 |
| X | DUTTA, Dhanadeep. Effect of Temperature on Positronium Annihilation in Silica Gel. The Journal of Physical Chemistry B. 29 April 2005, vol. 109, no. 20, pp. 10092-10095, DOI: 10.1021/jp050380g<br>abstract, p. 10095, left column, 3rd paragraph, table 1 | 1-4, 9 |

☑ Further documents are listed in the continuation of Box C.     ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **08 August 2023** | **29 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

# EP 4 541 768 A1

International application No.

**PCT/JP2023/022446**

## C.    DOCUMENTS CONSIDERED TO BE RELEVANT

| Category* | Citation of document, with indication, where appropriate, of the relevant passages | Relevant to claim No. |
|---|---|---|
| A | JP 2000-208451 A (TOKUYAMA CORP) 28 July 2000 (2000-07-28)<br>entire text, all drawings | 1-15 |
| A | WO 2015/087965 A1 (NISSAN CHEMICAL INDUSTRIES, LTD.) 18 June 2015 (2015-06-18)<br>entire text, all drawings | 1-15 |
| A | JP 2009-215088 A (NIHON YAMAMURA GLASS CO LTD) 24 September 2009 (2009-09-24)<br>entire text, all drawings | 1-15 |
| A | JP 2005-060217 A (FUSO CHEMICAL CO LTD) 10 March 2005 (2005-03-10)<br>entire text, all drawings | 1-15 |
| A | JP 2021-054684 A (JGC CATALYSTS & CHEMICALS LTD) 08 April 2021 (2021-04-08)<br>entire text, all drawings | 1-15 |
| A | JP 2018-167999 A (SAITO, Fuminaga) 01 November 2018 (2018-11-01)<br>entire text, all drawings | 1-15 |
| A | US 4897549 A (ZERDA, Tadeusz W.) 30 January 1990 (1990-01-30)<br>entire text, all drawings | 1-15 |
| A | DUTTA, D. Pore structure of silica gel: a comparative study through BET and PALS. Chemical Physics. June 2005, vol. 312, no. 1-3, pp. 319-324, DOI: 10.1016/j.chemphys.2004.12.008<br>entire text, all drawings | 1-15 |

INTERNATIONAL SEARCH REPORT
Information on patent family members

International application No.

**PCT/JP2023/022446**

| Patent document cited in search report | | | Publication date (day/month/year) | Patent family member(s) | | | Publication date (day/month/year) |
|---|---|---|---|---|---|---|---|
| JP | 2021-116225 | A | 10 August 2021 | (Family: none) | | | |
| WO | 2021/153502 | A1 | 05 August 2021 | US 2022/0363554 A1 examples, claims, paragraphs [0001], [0018]-[0141] EP 4098615 A1 CN 115023408 A KR 10-2022-0131926 A TW 202134179 A | | | |
| JP | 2021-147267 | A | 27 September 2021 | (Family: none) | | | |
| JP | 2000-208451 | A | 28 July 2000 | US 6338744 B1 entire text, all drawings EP 1020500 A1 TW 444053 B KR 10-2000-0057110 A | | | |
| WO | 2015/087965 | A1 | 18 June 2015 | US 2017/0001870 A1 entire text, all drawings EP 3081531 A1 CN 105813977 A KR 10-2016-0097287 A TW 201534562 A CN 113651335 A | | | |
| JP | 2009-215088 | A | 24 September 2009 | (Family: none) | | | |
| JP | 2005-060217 | A | 10 March 2005 | (Family: none) | | | |
| JP | 2021-054684 | A | 08 April 2021 | US 2021/0094833 A1 entire text, all drawings KR 10-2021-0038330 A TW 202114943 A | | | |
| JP | 2018-167999 | A | 01 November 2018 | (Family: none) | | | |
| US | 4897549 | A | 30 January 1990 | (Family: none) | | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H1160232 A
- JP 2019089692 A

- JP 2022099053 A

**Non-patent literature cited in the description**

- **K. WADA et al.** *J. Phys.: Conf. Ser.*, 2013, vol. 443, 012003